# EUROPEAN PATENT SPECIFICATION

(11) **EP 0 630 051 B1**
(45) Date of publication and mention of the grant of the patent: **01.09.1999**
(21) Application number: 93830261.9
(22) Date of filing: 15.06.1993
(51) Int. Cl.: H01L 27/07, H01L 27/06

(54) **Integrated structure bipolar switching transistor with controlled storage time**
Integrierte Struktur eines bipolaren Schalttransistors mit einer kontrollierten Speicherzeit
Structure intégrée d'un transistor bipolaire ou commutation ayant un temps d'emmagasinage contrôlé

(43) Date of publication of application: 21.12.1994
(73) Proprietor: Consorzio per la Ricerca sulla Microelettronica nel Mezzogiorno, 95121 Catania (IT)
(72) Inventor: Aparo, Sebastiano, I-96010 Solarino (Siracusa) (IT); Patti, Alfonso, I-95100 Catania (IT); Vitanza, Aldo, I-95030 Mascalucia (Catania) (IT)
(74) Representative: Mittler, Enrico

(56) References cited:
- EP-A- 0 020 233
- EP-A- 0 106 195
- FR-A- 2 101 228
- US-A- 3 670 219
- PATENT ABSTRACTS OF JAPAN vol. 009, no. 069 (E-305)29 March 1985 & JP-A-59 207 649 (FUJI DENKI SEIZO KK) 24 November 1984

## Description

The present invention relates with an integrated structure bipolar switching transistor with controlled storage time.

Bipolar transistors are frequently employed as switches in self-oscillating circuits, such as electronic ballasts for fluorescent lamps.

In such applications the switching transistor, during the "on" state, is deliberately overdriven; this gives rise to a significant storage of minority carrier charge, which causes the transistor to conduct for a certain time interval (called "storage time") after the base driving voltage is dropped. If the transistor's storage time is comparable with the oscillation period of the circuit, the power delivered to the load, as well as the circuit's oscillation frequency, are heavily affected. It is therefore necessary to make use of transistors having a well-known storage time, which moreover exhibit a low dispersion of this parameter from each other.

To achieve such objects, integrated circuits manufacturers make available different selections of transistors with guaranteed electrical characteristics; various techniques for controlling minority carrier lifetime are also known (introduction of dopant belonging to metallic species, electronic or protonic irradiation etc.).

An effective reduction of the storage time can also be achieved by providing the switching transistor with suitable integrated circuitry, such as Schottky diodes or antisaturation circuits.

Schottky diodes are generally connected in parallel to the base-collector junction of the switching transistor to clamp the voltage across the junction and limit the charge storage. Since, however, in current technology Schottky diodes cannot sustain reverse voltages of the order of 400V-700V, and since such values of voltage are encountered in some applications, this solution is impracticable.

A typical antisaturation circuit, known as "Baker clamp", comprises two junction diodes connected in series between an external base terminal and the base of the switching transistor, and a third junction diode with anode and cathode respectively connected to said base terminal and to the collector of the transistor. When the voltage drop across the first two diodes plus the base-collector voltage of the transistor is sufficient to turn-on the third diode, this last will start draining current from the base terminal, thus reducing the base current of the transistor; the base-collector junction of the transistor can never become forward-biased and the saturation of the switching transistor is consequently prevented.

A fourth junction diode, connected in parallel to the first two diodes but in the opposite direction (i.e., for an NPN switching transistor, with its anode and cathode connected to the base of the switching transistor and to the base terminal, respectively) is often provided in order to extract current from the base of the transistor when this is switched off.

A circuit like this cannot be directly integrated with bipolar switching transistors fabricated by known processes, because said first two diodes would have associated with them two parasitic transistors; in the case of an NPN switching transistor, the first two diodes would be constituted by two N+ diffusions (representing their cathode) obtained inside two P-type regions (representing their anode) which extend from the surface of the semiconductor inside an N- epitaxial layer representing the collector of the switching transistor; it appears that the cathode and anode regions of each diode, together with the collector of the switching transistor, represent the emitter, the base and the collector of a parasitic transistor.

To prevent such problem, a fabrication process which, similarly to those adopted for different integrated circuits, provides for the creation of insulating wells would be necessary.

Further integrated structures are disclosed in Pat. Abs. Jap Vol 9 no 69 (E-305) and JP-A-59 207 649, FR-A-2 458 146, FR-A-2 101 228, EP-A-106 195 and US-A-3 670 219.

In view of the state of art just described, the object of the present invention is to provide a device comprising a bipolar switching transistor with storage time controlled by an antisaturation circuit, which is not affected by the above-mentioned drawbacks.

According to the present invention, such object is attained by means of a device as set forth in claim 1.

Thanks to the present invention, it is possible to fabricate bipolar switching transistors with integrated antisaturation circuits by means of a traditional fabrication process, avoiding at the same time any problems related to parasitics elements.

These and further features of the present invention shall be made more evident by the following detailed description of its embodiments, illustrated as non-limiting examples in the annexed drawings, wherein:
Figure 1 shows a cross-sectional view of an integrated structure bipolar switching transistor not forming part of the claimed invention;
Figure 2 is an equivalent electric schematic diagram of said integrated structure;
Figure 3 is a plot (Atoms/cm³ versus Depth) of a doping concentration profile suitable to obtain said integrated structure;
Figure 4 shows a cross-sectional view of the integrated structure of Figure 1 provided with additional integrated components, according to the invention;
Figure 5 is an equivalent electric schematic diagram of the integrated structure of Figure 4;
Figure 6 is a simplified top view of a portion of the integrated structure of Figure 4;
Figure 7 is a simplified top view of another portion of said integrated structure.

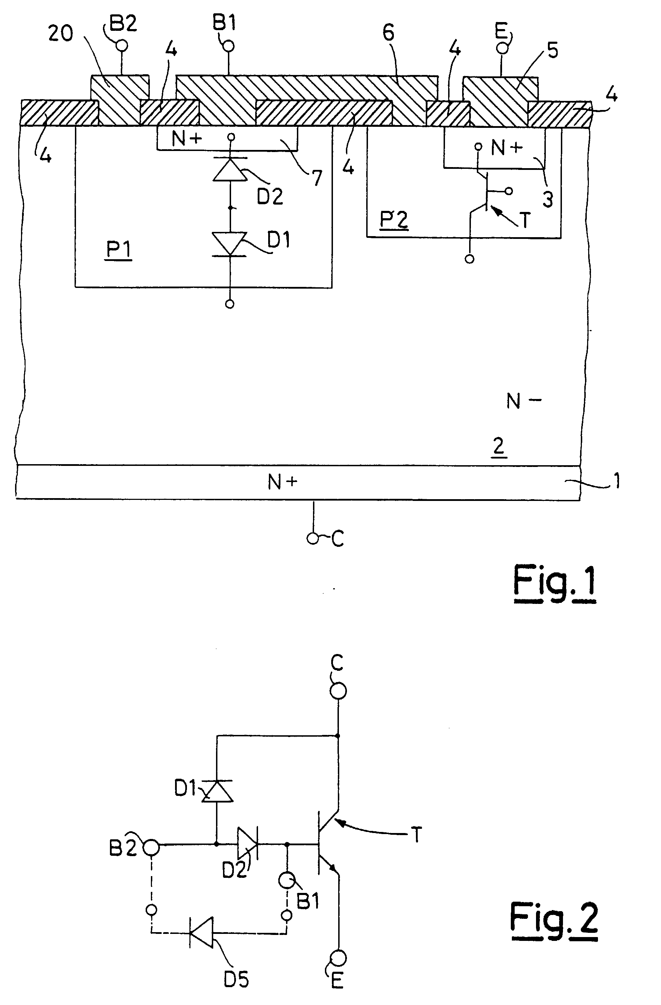

With reference to Figure 1, where the type of the various semiconductor regions refers to the case of an NPN switching transistor, over an N+ substrate 1 there is grown an N-epitaxial layer 2; together they constitute a collector region of a bipolar switching transistor T. A P-type region P2 extends from a top surface into the epitaxial layer 2 to form a base region of the transistor T; an N+ region 3 extends from said top surface within the region P2 and forms an emitter region for the transistor T. An insulating oxide layer 4 is superimposed over said top surface, and contact areas are provided to allow an emitter electrode 5 and a base electrode 6, both made for example of aluminium, to respectively contact the emitter region 3 and the base region P2 of the transistor T. The emitter electrode 5 and the base electrode 6 are also respectively connected to an emitter terminal E and to a first base terminal B1.

A further P-type region P1 extends, as P2 does, from the top surface into the epitaxial layer 2; within the region P1 there is diffused an N+ region 7, which is contacted at its top surface by the base electrode 6, while an electrode 20 connects the region P1 to a second base terminal B2. The emitter terminal E, the first base terminal B1 and the second base terminal B2, together with a collector terminal C connected to the bottom surface of the substrate 1, represent external terminals of the integrated component.

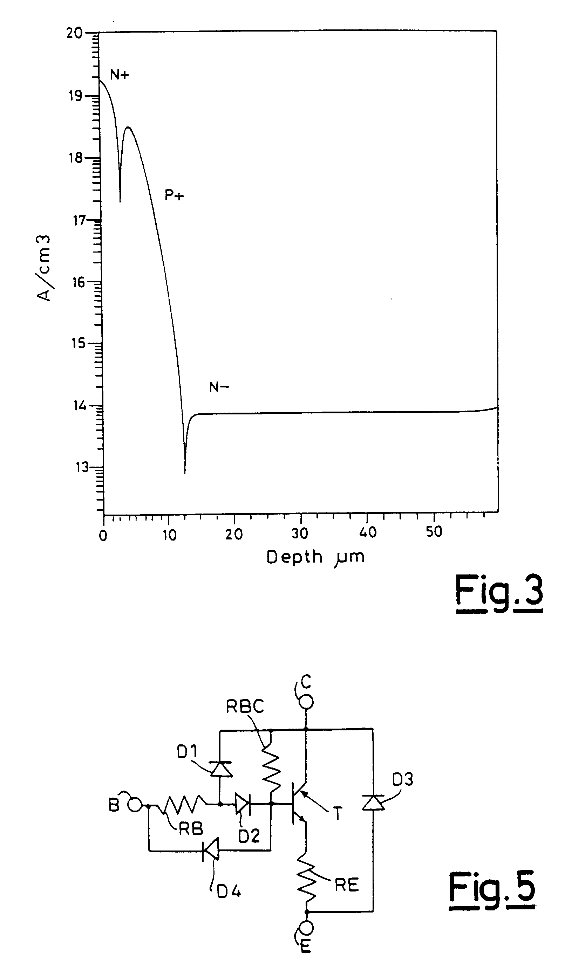

The doping level of the N+ region 7 and of the P-type region P1 is such that the doping profile of said regions (shown in Fig. 3), after dopant diffusion has been carried out, causes a parasitic transistor having emitter, base and collector respectively represented by the N+ region 7, the P-type region P1 and the epitaxial layer 2 to have a very low current gain; this parasitic transistor is thus totally equivalent to two junction diodes D1, D2 which have a common anode represented by the P-type region P1 and accessible through the second base terminal B2, and cathodes respectively represented by the epitaxial layer 2 (and thus by the collector of the switching transistor T) and by the N+ region 7 which is connected to the base of the switching transistor T. The whole structure correspond, in circuital terms, to the schematic of Fig. 2, corresponding to the above-mentioned "Baker clamp". The diode D1 clamps the base-collector voltage of transistor T to a maximum value of about 0V (supposing that D1 and D2 have equal turn-on voltages), thus preventing saturation to occur.

An external diode D5 can be back-connected between the first base terminal B1 and the second base terminal B2 (Fig. 2) to extract current from the base of transistor T when this is switched off, as previously described.

In Figure 4, showing a preferred embodiment of the present invention, several integrated components have been added to the structure of Figure 1, in order to improve its performances.

A third P-type region P3, extending from the top surface into the epitaxial layer 2, constitutes an anode of a third diode D3, whose cathode is represented by the epitaxial layer 2 and thus by the collector of the switching transistor T; an N+ region 8, diffused within the P-type region P3, is contacted at one side by the emitter electrode 5 which also contacts the emitter region 3 of transistor T; the emitter terminal E is connected, by means of a conductive metal strip 9, to the opposite side of the N+ region 8 and to the P-type region P3. The N+ region 8 introduces a resistance RE in series between the emitter 3 of transistor T and the emitter terminal E, to which there is also connected the anode of diode D3; the diode D3, being back-connected in parallel between the collector terminal C and the emitter terminal E, behaves as a damper.

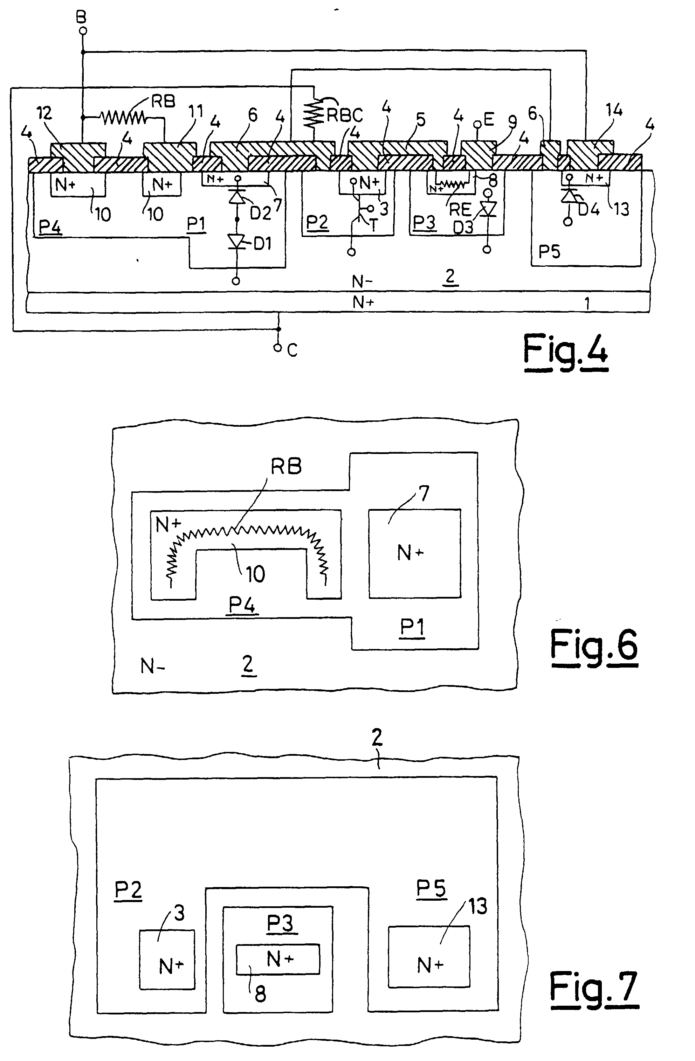

One side of the P-type region P1 is merged with a fourth P-type region P4, in which an N+ region 10 is obtained (Fig. 6); one end of the N+ region 10 is short-circuited to the P-type regions P1 and P4 by means of a metal strip 11, while the opposite end is connected, through a metal strip 12, to a base terminal B of the component. The N+ region 10 introduces, in series between the common anodes of diodes D1 and D2 and the base terminal B, a resistance RB.

A fifth P-type region P5 is merged with the P-type region P2 representing the base of transistor T (Fig. 7); an N+ region 13 is diffused within the P-type region P5, the doping profile of regions P5 and 13 being similar to that of regions P1 and 7, shown in Figure 3. This assures that a parasitic transistor having emitter, base and collector respectively represented by the N+ region 13, the P-type region P5 and the epitaxial layer 2 has a very low current gain, and is almost equivalent to two back-connected diodes, as in the case of diodes D1 and D2. The P-type region P5 is contacted by the base electrode 6, while the N+ region 13 is connected, by means of a metal strip 14, to the base terminal B. This arrangement causes a diode D4, represented by the base-emitter junction of said parasitic transistor, to be connected between the base of the switching transistor T and the base terminal B, as shown in Figure 5; such diode D4 provides the extraction of current from the base of transistor T when this last is switched off, and performs the function of the above mentioned external diode D5. This leads to a reduction in space and costs, since the base terminal B1 and the respective bonding wire are no more necessary; moreover, the higher is the number of components that are integrated on the same chip, the lower is the area of the printed circuit board required.

The resistances RB and RE have typical values of about 5ohm-50ohm and 0.4ohm-2ohm respectively, and are useful in several applications, for example for balancing a bridge circuit in which the switching transistor T is inserted.

A further resistance RBC shunting the base and the collector of transistor T (which can be externally connected between terminals B1 and C in the arrangement of Figures 1 and 2 or integrated by any known technique in the arrangement of Figures 4 and 5) is useful to assure the oscillation start-up in applications involving a self-oscillating circuit; typical values for said resistance are 100Kohm-1Mohm.

A further improvement of the performances of the integrated structure antisaturation circuit can be achieved by the introduction of any species of lifetime-killing impurities in the P-type region P1 representing the base of the parasitic transistor; this would reduce the storage time of the base-collector junction of said parasitic transistor to negligible levels.

As it is clear to anyone skilled in the art, the invention applies as well to PNP switching transistor; in this case it is necessary to substitute all P-type regions for N-type regions, and vice-versa.

## Claims

1. A device comprising an integrated structure bipolar switching transistor (T) and an antisaturation circuit (D1,D2,D4), the switching transistor constituted by an emitter region (3) of a first conductivity type extending from a top surface of a semiconductor material (2) within a base region (P2) of a second conductivity type which extends from said top surface into a collector region represented by said semiconductor material (2) of the first conductivity type, the antisaturation circuit comprising a first junction diode (D1) and a second junction diode (D2), formed respectively by a base-collector junction and an emitter-base junction of a zero-gain bipolar transistor and said second junction diode being connected to an external base terminal (B) and the said base region and said first junction diode being connected between the external base terminal and the collector region of the switching transistor, and a third junction diode (D4) connected between the external base terminal and the said base region in opposition to the first and second junction diodes,
characterized in that
said zero-gain transistor is integrated in said semiconductor material (2) and comprises a first semiconductor region (P1) of the second conductivity type extending from said top surface into the semiconductor material, within which a second semiconductor region (7) of the first conductivity is provided also extending from said top surface, the first and second semiconductor regions having respective doping profiles defining the zero-gain transistor whose base, emitter and collector are respectively represented the first and second semiconductor regions and the semiconductor material, the first and second semiconductor regions respectively connected to the external base terminal and to the base region of the switching transistor,
and in that
said third junction diode (D4) comprises a third semiconductor region (P5) of the second conductivity type extending from said top surface within the semiconductor material and merged with said base region (P2), and a fourth semiconductor region (13) of the first conductivity type extending from said top surface within the third semiconductor region and connected to the external base terminal (B), the third and fourth semiconductor regions having doping profiles similar to those of the first and second semiconductor regions, respectively, so that a further zero-gain transistor is formed whose emitter-base junction forms said third diode (D4).

2. A device according to claim 1, characterized in that an integrated resistance (RE) is provided, which is connected in series between the emitter region (3) of the bipolar switching transistor (T) and an external emitter terminal (E).

3. A device according to claim 1, characterized in that a fifth semiconductor region (P3) of the second conductivity type is provided which extends from said top surface into said semiconductor material (2) of the first conductivity type, said fifth semiconductor region (P3) being electrically connected to the emitter region (3) of the bipolar switching transistor (T) in order to form a damper diode (D3) having a first electrode, represented by the fifth region (P3), electrically connected to the emitter of the bipolar switching transistor (T) and a second electrode, represented by said semiconductor material (2), electrically connected to the collector of the switching transistor (T).

4. A device according to claim 3, characterized in that an integrated resistance (RE) is provided, which is connected in series between the emitter region (3) of the bipolar switching transistor (T) and an external emitter terminal (E) to which the first electrode of the damper diode (D3) is also connected.

5. A device according to claim 4, characterized in that said integrated resistance (RE) is constituted by a semiconductor region (8) of the first conductivity type provided within said fifth semiconductor region (P3), connected at one side to the emitter region (3) of the transistor (T) and at another side to the external emitter terminal (E).

6. A device according to any of the preceding claims, characterized in that it further comprises an integrated resistance (RB) which is serially connected between the external base terminal (B) and said second diode (D2).

7. A device according to claim 6, characterized in that said integrated resistance (RB) is constituted by a semiconductor region (10) of the first conductivity type obtained inside a sixth region (P4) of the second conductivity type which is merged with said first semiconductor region (P1) of the second conductivity type.

8. A device according to any of the preceding claims, characterized in that a further resistance (RBC) is provided connecting the base and the collector of said switching transistor (T).

9. A device according to any of the preceding claims, characterized in that said first semiconductor region (P1) includes lifetime-killing dopants suitable to reduce the storage-time of said zero-gain transistor.

10. A device according to any of the preceding claims, characterized in that said semiconductor material (2) of the first conductivity type is an epitaxial layer (2) grown on a semiconductor substrate (1) of the first conductivity type.

11. A device according to any of the preceding claims, characterized in that said semiconductor regions (3,7,8,10,13), said semiconductor material (2) and said semiconductor substrate (1) of the first conductivity type are semiconductor regions doped with donor impurities, while said semiconductor regions (P1,P2,P3,P4,P5) of the second conductivity type are semiconductor regions doped with acceptor impurities.

12. A device according to anyone of claims from 1 to 10, characterized in that said semiconductor regions (3,7,8,10,13), said semiconductor material (2) and said semiconductor substrate (1) of the first conductivity type are semiconductor regions doped with acceptor impurities, while said semiconductor regions (P1,P2,P3,P4,P5) of the second conductivity type are semiconductor regions doped with donor impurities.

## Patentansprüche

1. Vorrichtung mit einem bipolaren Schalttransistor (T) integrierter Struktur und einer Antisättigungsschaltung (D1, D2, D4),
wobei der Schalttransistor durch einen Emitterbereich (3) eines ersten Leitungstypes realisiert ist, der sich von einer oberen Oberfläche eines Halbleitermaterials (2) innerhalb eines Basisbereiches (P2) eines zweiten Leitungstypes erstreckt, der sich von der oberen Oberfläche in einen Kollektorbereich erstreckt, der durch das Halbleitermaterial (2) des ersten Leitungstypes realisiert ist,
wobei die Antisättigungsschaltung aufweist eine erste Sperrschichtdiode (D1) und eine zweite Sperrschichtdiode (D2), die durch einen Basis-Kollektor-Übergang bzw. einen Emitter-Basis-Übergang eines verstärkungslosen bipolaren Transistors gebildet sind, wobei die zweite Sperrschichtdiode mit einem externen Basisanschluß (B) und dem Basisbereich verbunden ist und die erste Sperrschichtdiode zwischen den externen Basisanschluß und den Kollektorbereich des Schalttransistors geschaltet ist, und eine dritte Sperrschichtdiode (D4), die zwischen den externen Basisanschluß und den Basisbereich gegenüber zu der ersten und zweiten Sperrschichtdiode geschaltet ist,
dadurch gekennzeichnet,
daß der verstärkungslose Transistor in das Halbleitermaterial (2) integriert ist und einen ersten Halbleiterbereich (P1) des zweiten Leitungstypes aufweist, der sich von der oberen Oberfläche in das Halbleitermaterial erstreckt, in dem ein zweiter Halbleiterbereich (7) des ersten Leitungstypes vorgesehen ist, der sich ebenfalls von der oberen Oberfläche erstreckt, wobei der erste und zweite Halbleiterbereich entsprechend dotierte Profile aufweisen, die den verstärkungslosen Transistor definieren, dessen Basis, Emitter und Kollektor von dem ersten und dem zweiten Halbleiterbereich bzw. dem Halbleitermaterial realisiert sind, der erste und zweite Halbleiterbereich mit dem externen Basisanschluß bzw. dem Basisbereich des Schalttransistors verbunden sind,
und dadurch,
daß die dritte Sperrschichtdiode (D4) aufweist einen dritten Halbleiterbereich (P5) des zweiten Leitungstypes, der sich von der oberen Oberfläche innerhalb des Halbleitermateriales erstreckt und mit den Basisbereichen (P2) verschmolzen ist, und einen vierten Halbleiterbereich (13) des ersten Leitungstypes, der sich von der oberen Oberfläche innerhalb des dritten Halbleiterbereiches erstreckt und mit dem externen Basisanschluß (B) verbunden ist, wobei der dritte und vierte Halbleiterbereich Dotierungsprofile ähnlich zu jenen des ersten bzw. des zweiten Halbleiterbereiches aufweisen, so daß ein weiterer verstärkungsloser Transistor gebildet ist, dessen Emitter-Basis-Übergang die dritte Diode (D4) bildet.

2. Vorrichtung nach Anspruch 1,
dadurch gekennzeichnet, daß ein integrierter Widerstand (RE) vorgesehen ist, der in Reihe zwischen den Emitterbereichen (3) des bipolaren Schalttransistors (T) und einen externen Emitteranschluß (E) geschaltet ist.

3. Vorrichtung nach Anspruch 1,
dadurch gekennzeichnet, daß ein fünfter Halbleiterbereich (P3) des zweiten Leitungstypes vorgesehen ist, der sich von der oberen Oberfläche in das Halbleitermaterial (2) des ersten Leitungstypes erstreckt, wobei der fünfte Halbleiterbereich (P3) elektrisch mit dem Emitterbereich (3) des bipolaren Schalttransistors (T) zum Bilden einer Dämpfungsdiode (D3) verbunden ist, die eine erste Elektrode, die durch den fünften Bereich (P3) realisiert ist, der elektrisch mit dem Emitter des bipolaren Schalttransistors (T) verbunden ist, und eine zweite Elektrode, die durch das Halbleitermaterial (2) realisiert ist, das elektrisch mit dem Kollektor des Schalttransistors (T) verbunden ist, aufweist.

4. Vorrichtung nach Anspruch 3,
dadurch gekennzeichnet, daß ein integrierter Widerstand (RE) vorgesehen ist, der in Reihe zwischen den Emitterbereichen (3) des bipolaren Schalttransistors (T) und einen externen Emitteranschluß (E) geschaltet ist, mit dem die erste Elektrode der Dämpfungsdiode (D3) ebenfalls verbunden ist.

5. Vorrichtung nach Anspruch 4,
dadurch gekennzeichnet, daß der integrierte Widerstand (RE) durch einen Halbleiterbereich (8) des ersten Leitungstypes realisiert ist, der innerhalb des fünften Halbleiterbereiches (P3) vorgesehen ist, der an einer Seite mit dem Emitterbereich (3) des Transistors (T) und an der anderen Seite mit dem externen Emitteranschluß (E) verbunden ist.

6. Vorrichtung nach einem der vorhergehenden Ansprüche,
dadurch gekennzeichnet, daß sie weiter einen integrierten Widerstand (RB) aufweist, der in Reihe zwischen den externen Basisanschluß (B) und die zweite Diode (D2) geschaltet ist.

7. Vorrichtung nach Anspruch 6, dadurch gekennzeichnet, daß der integrierte Widerstand (RB) durch einen Halbleiterbereich (10) des ersten Leitungstypes realisiert ist, der innerhalb eines sechsten Bereiches (P4) des zweiten Leitungstypes erhalten ist, der mit dem ersten Halbleiterbereich (P1) des zweiten Leitungstypes verschmolzen ist.

8. Vorrichtung nach einem der vorhergehenden Ansprüche,
dadurch gekennzeichnet, daß ein weiterer Widerstand (RBC) vorgesehen ist, der die Basis und den Kollektor des Schalttransistors (T) verbindet.

9. Vorrichtung nach einem der vorhergehenden Ansprüche,
dadurch gekennzeichnet, daß der erste Halbleiterbereich (P1) Lebensdauerunterdrückungsdotiermittel aufweist, die geeignet sind zum Verringern der Speicherzeit des verstärkungslosen Transistors.

10. Vorrichtung nach einem der vorhergehenden Ansprüche,
dadurch gekennzeichnet, daß das Halbleitermaterial (2) des ersten Leitungstypes eine Epitaxialschicht (2) ist, die auf ein Halbleitersubstrat (1) des ersten Leitungstypes gewachsen ist.

11. Vorrichtung nach einem der vorhergehenden Ansprüche,
dadurch gekennzeichnet, daß die Halbleiterbereiche (3, 7, 8, 10, 13), das Halbleitermaterial (2) und das Halbleitersubstrat (1) des ersten Leitungstypes Halbleiterbereiche sind, die mit Donatordotiermittel dotiert sind, während die Halbleiterbereiche (P1, P2, P3, P4, P5) des zweiten Leitungstypes Halbleiterbereiche sind, die mit Akzeptordotiermittel dotiert sind.

12. Vorrichtung nach einem der Ansprüche 1 bis 10,
dadurch gekennzeichnet, daß die Halbleiterbereiche (3, 7, 8, 10, 13), das Halbleitermaterial (2) und das Halbleitersubstrat (1) des ersten Leitungstypes Halbleiterbereiche sind, die mit Akzeptordotiermittel dotiert sind, während die Halbleiterbereiche (P1, P2, P3, P4, P5) des zweiten Leitungstypes Halbleiterbereiche sind, die mit Donatordotiermittel dotiert sind.

## Revendications

1. Dispositif intégré comprenant un transistor bipolaire de commutation (T) et un circuit antisaturation (D1, D2, D4), le transistor de commutation étant constitué d'une région d'émetteur (3) d'un premier type de conductivité s'étendant à partir d'une surface supérieure d'un matériau semiconducteur (2) dans une région de base (P2) d'un second type de conductivité qui s'étend à partir de la surface supérieure dans une région de collecteur constituée par le matériau semiconducteur (2) du premier type de conductivité, le circuit antisaturation comprenant une première diode à jonction (D1) et une deuxième diode à jonction (D2) formées respectivement par la jonction base/collecteur et par la jonction émetteur/base d'un transistor bipolaire à gain nul, la deuxième diode à jonction étant connectée à une borne de base externe (B) et à ladite région de base, et la première diode à jonction étant connectée entre la borne de base externe et la région de collecteur du transistor de commutation, et une troisième diode à jonction (D4) connectée entre la borne de base externe et la région de base en opposition avec les première et deuxième diodes à jonction ;
caractérisé en ce que :
le transistor à gain nul est intégré dans le matériau semiconducteur (2) et comprend une première région semiconductrice (P1) du second type de conductivité s'étendant à partir de la surface supérieure dans le matériau semiconducteur, dans lequel une deuxième région semiconductrice (7) du premier type de conductivité est prévue et s'étend également à partir de la surface supérieure, les première et deuxième régions semiconductrices ayant des profils de dopage respectifs définissant le transistor à gain nul dont la base, l'émetteur et le collecteur sont respectivement représentés par les première et deuxième régions semiconductrices et le matériau semiconducteur, les première et deuxième régions semiconductrices étant respectivement connectées à la borne de base externe et à la région de base du transistor de commutation, et
la troisième diode à jonction (D4) comprend une troisième région semiconductrice (P5) du second type de conductivité s'étendant à partir de la surface supérieure dans le matériau semiconducteur et se confondant avec la région de base (P2), et une quatrième région semiconductrice (13) du premier type de conductivité s'étendant à partir de la surface supérieure de la troisième région semiconductrice et étant connectée à la borne de base externe (B), les troisième et quatrième régions semiconductrices ayant des profils de dopage similaires à ceux des première et deuxième régions semiconductrices, respectivement, de sorte qu'un autre transistor à gain nul est formé dont la jonction émetteur/base forme la troisième diode (D4).

2. Dispositif selon la revendication 1, caractérisé en ce qu'il comprend une résistance intégrée (RE) connectée en série entre la région d'émetteur (3) du transistor de commutation bipolaire (T) et une borne d'émetteur externe (E).

3. Dispositif selon la revendication 1, caractérisé en ce qu'une cinquième région semiconductrice (P3) du second type de conductivité est prévue et s'étend à partir de la surface supérieure dans le matériau semiconducteur (2) du premier type de conductivité, la cinquième région semiconductrice (P3) étant électriquement connectée à la région d'émetteur (3) du transistor de commutation bipolaire (T) pour former une diode d'amortissement (D3) ayant une première électrode représentée par la cinquième région (P3), électriquement connectée à l'émetteur du transistor bipolaire de commutation (T) et une seconde électrode, constituée par le matériau semiconducteur (2), électriquement, connectée au collecteur du transistor de commutation.

4. Dispositif selon la revendication 3, caractérisé en ce qu'il comprend une résistance intégrée (RE) connectée en série entre la région d'émetteur (3) du transistor bipolaire de commutation (T) et une borne d'émetteur externe (E) à laquelle la première électrode de la diode d'amortissement (D3) est également connectée.

5. Dispositif selon la revendication 4, caractérisé en ce que la résistance intégrée (RE) est constituée d'une région semiconductrice (8) du premier type de conductivité prévue dans la cinquième région semiconductrice (P3), connectée d'un côté à la région d'émetteur (3) du transistor (T) et de l'autre à la borne externe d'émetteur (E).

6. Dispositif selon l'une quelconque des revendications précédentes, caractérisé en ce qu'il comprend en outre une résistance intégrée (RB) connectée en série entre la borne de base externe (B) et la deuxième diode (D2).

7. Dispositif selon la revendication 6, caractérisé en ce que la résistance intégrée (RB) est constituée d'une région semiconductrice (10) du premier type de conductivité formée à l'intérieur d'une sixième région (P4) du second type de conductivité qui est confondue avec la première région semiconductrice (P1) du second type de conductivité.

8. Dispositif selon l'une quelconque des revendications précédentes, caractérisé en ce qu'il comprend une autre résistance (RBC) reliant la base et le collecteur du transistor de commutation (T).

9. Dispositif selon l'une quelconque des revendications précédentes, caractérisé en ce que la première région semiconductrice (P1) comprend des dopants tueurs de durée de vie propres à réduire le temps de stockage du transistor à gain nul.

10. Dispositif selon l'une quelconque des revendications précédentes, caractérisé en ce que le matériau semiconducteur (2) du premier type de conductivité est une couche épitaxiale (2) amenée à croître sur un substrat semiconducteur (1) du premier type de conductivité.

11. Dispositif selon l'une quelconque des revendications précédentes, caractérisé en ce que les régions semiconductrices (3, 7, 8, 10, 13), le matériau semiconducteur (2) et le substrat semiconducteur (1) du premier type de conductivité sont des régions semiconductrices dopées par des impuretés donneuses tandis que les régions semiconductrices (P1, P2, P3, P4, P5) du second type de conductivité sont des régions semiconductrices dopées par des impuretés d'accepteur.

12. Dispositif selon l'une quelconque des revendications précédentes, caractérisé en ce que le régions semiconductrices (3, 7, 8, 10, 13), le matériau semiconducteur (2) et le substrat semiconducteur (1) du premier type de conductivité sont des régions semiconductrices dopées par des impuretés d'accepteur tandis que les régions semiconductrices (P1, P2, P3, P4, P5) du second type de conductivité sont des régions semiconductrices dopées par des impuretés donneuses.
